# EUROPEAN PATENT APPLICATION

(11) **EP 0 631 329 A1**
(43) Date of publication of application: **28.12.1994**
(21) Application number: 93110188.5
(22) Date of filing: 25.06.1993
(51) Int. Cl.: H01L 31/075, H01L 31/20, H01L 31/0224

(54) **Process for producing amorphous silicon solar cell**

(71) Applicant: Showa Shell Sekiyu K.K., Tokyo (JP)
(72) Inventor: Sichanugrist, Porponth, Yokosuka-shi, Kanagawa (JP); Nii, Tetsuro, c/o Showa Shell Sekiyu K.K., Tokyo (JP); Kase, Takahisa, c/o Showa Shell Sekiyu K.K., Tokyo (JP)
(74) Representative: Hansen, Bernd, Dr. Dipl.-Chem.

(57) **Abstract**

A process for producing an amorphous silicon solar cell comprising an insulating transparent substrate (1) with a transparent electrode layer (2) having formed thereon an amorphous silicon layer having a p-i-n junction and a back selectrode layer, which process contains a step of forming an amorphous silicon oxide layer (3) between the transparent electrode layer (2) and a p-type layer (4) by glow discharge in an atmosphere containing carbon dioxide; a step of forming a p-type amorphous silicon carbide layer (4) using a reactive gas mixture comprising silane, methane, and diborane having incorporated therein a proper amount of trimethylboron; a step of forming a first back electrode (7) on an n-type layer (6) by sputtering while doping a metal into a target material and forming a second back electrode (8) on the first back electrode, followed by a heat treatment.

## Description

### FIELD OF THE INVENTION

This invention relates to a process for producing an amorphous silicon solar cell which can be used in integrated solar cells or photo sensors.

### BACKGROUND OF THE INVENTION

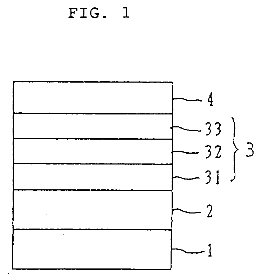

A unit solar cell comprising amorphous silicon (hereinafter abbreviated as a-Si) basically has the layer structure shown in Fig. 1, which is composed of insulating substrate 1 having laminated thereon transparent electrode layer 2, a-Si layer 3, and metallic back electrode layer 4 in this order.

A unit solar cell of this type is usually produced as follows. Transparent electrode layer 2 comprising a transparent conductive film of tin oxide (SnO₂), zinc oxide (ZnO), indium-tin oxide, etc. is formed on glass substrate 1 to a thickness of about 4500 to 20000 Å by thermal CVD or sputtering. It is widespread to subject transparent electrode layer 2 to a glow discharge treatment in hydrogen gas as hereinafter described. On transparent electrode layer 2 are deposited p-type amorphous silicon carbide (hereinafter referred to as a-SiC) layer 31 to a thickness of about 100 Å, intrinsic a-Si layer 32 to a thickness of from 0.1 to 0.4 µm, and n-type a-Si layer to a thickness of about 300 Å in this order by glow discharge decomposition of silane gas to form a-Si layer 3 having a p-i-n junction. The p-type layer contains boron and carbon, and the n-type layer contains phosphorus as dopants. Finally, back electrode 4 comprising, for example, aluminum, zinc oxide, silver, copper or the like, is formed on a-Si layer 3 by sputtering or vacuum evaporation.

A hydrogen glow discharge treatment before deposition of p-type a-SiC is known as a means for improving performance properties of a-Si solar cells. The hydrogen glow discharge treatment of a transparent electrode layer improves contact characteristics with the p-type layer to thereby increase conversion efficiency of solar cells.

However, if a transparent electrode layer comprising SnO₂ is subjected to a hydrogen glow discharge treatment for an extended treating time, SnO₂ undergoes reduction to Sn, which leads to a reduction in transmission of the SnO₂ layer. As a result, the amount of light absorbed by the a-Si layer is reduced, giving adverse influences on the performance of the solar cell. Where a transparent electrode layer comprises ZnO, the hydrogen glow discharge treatment fails to improve the contact characteristics between ZnO and the p-type layer, hardly improving the performance characteristics.

Further, the conventional p-type a-Si layer incurs a large absorption loss because of its narrow optical forbidden band width (hereinafter referred to as an Eₒₚₜ) and a large absorption coefficient.

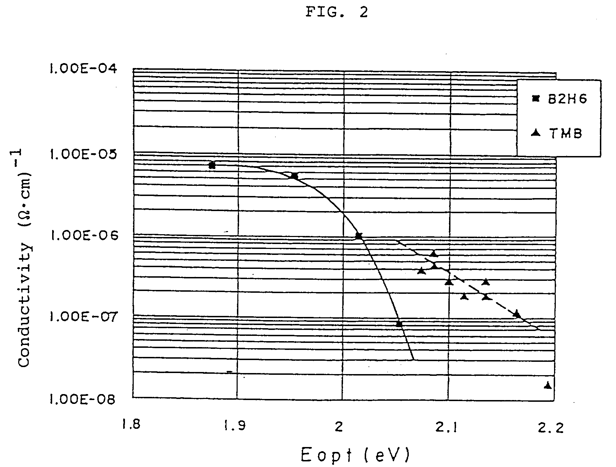

In order to overcome this disadvantage, a-SiC having a broader Eₒₚₜ than that of the conventional p-type a-Si has been developed as disclosed, e.g., in EP-A-53402. The p-type a-SiC is obtained by glow discharge decomposition of a mixed gas of silane gas (SiH₄), methane (CH₄), and hydrogen (H₂) using diborane (B₂H₆) as a dopant. In recent years, trimethylboron (B(CH₃)₃) (hereinafter abbreviated as TMB) has been proposed as a dopant capable of deriving more effects of boron as reported in Japanese Journal of Applied Physics, Vol. 28, No. 12, pp. 2436-2440 (Dec., 1989). In Fig. 2 is shown a graph of Eₒₚₜ vs. conductivity of an a-SiC layer when deposited by using each of these doping gases. As can be seen from Fig. 2, in using TMB as a dopant, as the amount of the dopant increases, the conductivity decreases. Accordingly, in order to obtain high efficiency, it has been demanded to develop p-type a-SiC having a wider Eₒₚₜ and a high conductivity.

On the other hand, it is known effective for improving conversion efficiency to form a back electrode having a double layer structure composed of a first back electrode which is formed on an n-type layer and serves to scatter transmitted light and a second back electrode for completely confining the light scattered in the first back electrode. For example, the first back electrode is formed of zinc oxide, and the second back electrode is formed of aluminum, silver, copper, etc. However, depending on the characteristics of the zinc oxide used in the first back electrode, for example where zinc oxide has high resistance or low conductivity, the shunt resistance is increased by zinc oxide, or the contact resistance between the n-type layer and the zinc oxide layer increases, giving adverse influences on the conversion efficiency of the solar cell.

### SUMMARY OF THE INVENTION

An object of the present invention is to provide a process for producing a high performance a-Si solar cell having improved contact characteristics between a transparent electrode layer comprising SnO₂ or ZnO and a p-type layer.

Another object of the present invention is to provide a process for forming a p-type a-SiC layer having a broad Eₒₚₜ and a high conductivity.

A further object of the present invention is to provide a process for producing a high performance a-Si solar cell having an increased fill factor by improving the characteristics of zinc oxide as a first back electrode layer.

The first object of the present invention is accomplished by a first embodiment consisting in a process for producing a solar cell comprising an insulating transparent substrate with a transparent electrode layer having formed thereon an a-Si layer having a p-i-n junction and a back electrode layer in this order, which comprises forming an amorphous silicon oxide layer (hereinafter referred to as an a-SiO layer) between the transparent electrode layer and the p-type layer by glow discharge in an atmosphere containing carbon dioxide.

According to this embodiment, carrier recombination between the transparent electrode and the p-type layer can be accelerated by the very thin a-SiO layer provided therebetween. As a result, the contact resistance between the two layers is reduced to thereby improve the performance of the solar cell.

The second object of the present invention is accomplished by a second embodiment consisting in a process for producing a solar cell comprising an insulating transparent substrate with a transparent electrode layer having formed thereon an a-Si layer having a p-i-n junction and a back electrode layer in this order, which comprises forming a p-type a-SiC layer using a reactive gas mixture comprising silane, methane, and diborane having incorporated therein a proper amount of TMB. The TMB/silane flow ratio is preferably from 0.3 to 0.6%, more preferably from 0.4 to 0.5%, and most preferably about 0.45%.

According to the second embodiment, incorporation of a proper amount of TMB into a reactive gas for p-type a-SiC formation makes it feasible to increase the Eₒₚₜ by about 0.1 eV without causing a reduction in conductivity.

The third object of the present invention is accomplished by a third embodiment consisting in a process for producing an a-Si solar cell having a p-i-n junction in which the n-type layer is a microcrystalline silicon layer formed by plasma CVD, the process including a step in which a first back electrode is formed on the n-type layer by sputtering while doping a metal into a target material, a step of forming a second back electrode on the first back electrode, and a step of conducting a heat treatment after the formation of the second back electrode. The first back electrode is preferably formed of zinc oxide by using a target material (zinc oxide) containing aluminum as a dopant.

According to the third embodiment, the ohmic junction between the n-type layer and the zinc oxide layer can be improved by conducting a heat treatment after formation of a first back electrode on an n-type a-Si layer by sputtering, thereby improving the fill factor.

Accomplishment of the objects of the present invention can further be ensured by appropriately combining the above-mentioned three embodiments.

### DESCRIPTION OF PREFERRED EMBODIMENTS

The present invention will be illustrated in more detail with reference to the following Examples, but it should be understood that the present invention is not construed as being limited thereto.

### EXAMPLE 1

a-Si solar cells according to the first embodiment of the present invention were prepared as follows.

SnO₂ was deposited on glass substrate 1 in Fig. 1 by thermal CVD to a thickness of about 4500 Å to form transparent electrode layer 2 and then subjected to a glow discharge treatment in carbon dioxide (CO₂) (hereinafter referred to as a CO₂ glow discharge treatment) for a varied treating time to form a very thin a-SiO layer having a thickness of not more than about 30 Å.

In Example 1, the CO₂ glow discharge was driven at a high frequency in a low pressure atmosphere containing CO₂. Conditions of the CO₂ glow discharge treatment adopted here were as follows.

### Conditions of CO₂ Glow Discharge:

Substrate temperature: 200°C
Pressure: 0.5 Torr
Power density: about 25 mW/cm²
CO₂ flow rate: 30 sccm
After the CO₂ glow discharge treatment, the vacuum condition was maintained, and a-Si layer 3 having a p-i-n junction was deposited by plasma CVD to a deposit thickness of about 0.12 µm. Aluminum was then deposited thereon to a thickness of about 500 Å by vacuum evaporation to form a back electrode.

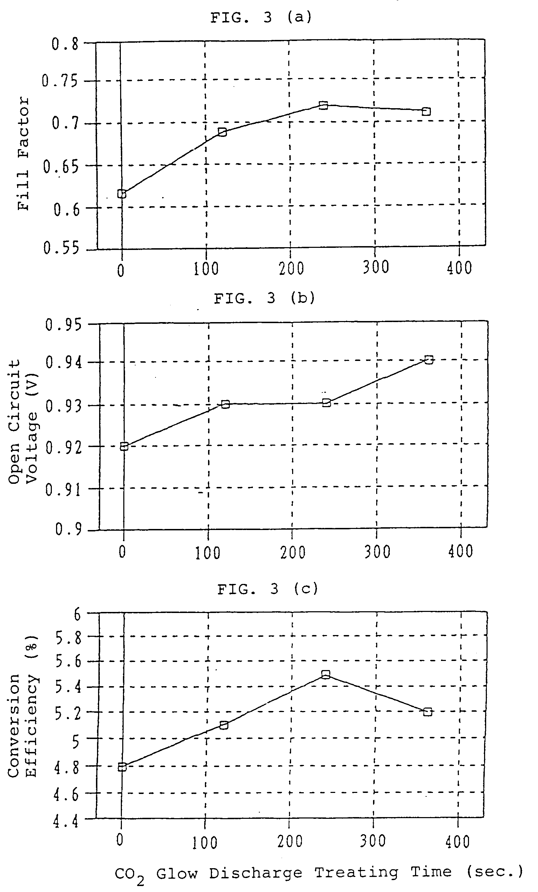

The influence of the CO₂ glow discharge treating time on various performance properties of the resulting solar cell was examined. The results obtained are shown in Fig. 3. Figs. 3(a), 3(b), and 3(c) show the influence on the fill factor, open circuit voltage, and conversion efficiency, respectively.

In order to examine the influence of power density in the CO₂ glow discharge treatment on these characteristics, the CO₂ glow discharge treatment was carried out at a power density of about 25, 50 or 75 mW/cm² for a treating time fixed at 240 seconds with the other conditions being the same as above. The resulting solar cell is designated Sample 1. As a result, no change in characteristics was observed.

For comparison, a solar cell was prepared in the same manner as described above, except for conducting a conventional H₂ glow discharge treatment under the following conditions in place of the CO₂ glow discharge treatment.

### Conditions of H₂ Glow Discharge:

Substrate temperature: 200°C
Pressure: 0.5 Torr
Power density: 42 mW/cm²
H₂ flow rate: 300 sccm
Treating Time: 36 seconds
Various characteristics of Sample 1 (CO₂ glow discharge treating time: 240 seconds) and those of the comparative solar cell prepared above are shown in Table 1 below.

**TABLE 1**

| Solar Cell | Efficiency (%) | Open Circuit Voltage (V) | Short-Circuited Current (mA/cm²) | Fill Factor |
|---|---|---|---|---|
| Conventional | 4.7 | 0.92 | 7.62 | 0.67 |
| Invention (Sample 1) | 5.5 | 0.93 | 8.20 | 0.72 |

It is seen that the solar cell according to the present invention shows improvements in all the characteristics examined, especially short-circuited current and fill factor, over the solar cell prepared by the conventional H₂ glow discharge treatment.

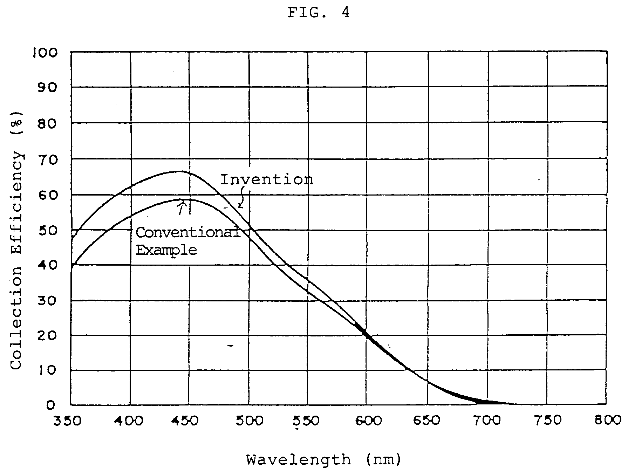

In Fig. 4 is shown the collection efficiency of Sample 1 at various wavelengths in comparison with that of the comparative solar cell. As is apparent from the Fig., the solar cell prepared by the CO₂ glow discharge treatment attains a higher collection efficiency because the SnO₂ layer suffered from no reduction in light transmission by the CO₂ glow discharge treatment.

Solar cells in which ZnO was used as a transparent electrode layer were prepared as follows. ZnO was deposited on glass substrate 1 by thermal CVD to a thickness of about 20000 Å and then subjected to a CO₂ glow discharge treatment under the same conditions as described above. While keeping the vacuum condition, a-Si layer having a p-i-n junction was formed by plasma CVD to a deposit thickness of about 0.4 µm. Silver was then deposited thereon by vacuum evaporation to a thickness of about 3700 Å to form a back electrode.

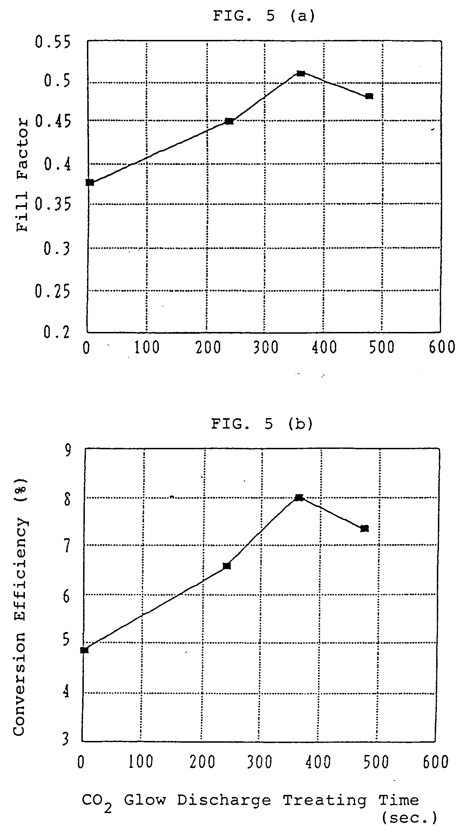

Figs. 5(a) and 5(b) show the influence of the CO₂ glow discharge treating time on the fill factor and conversion efficiency, respectively. It is seen that both the fill factor and efficiency increase with the treating time similarly to the cases where SnO₂ was used as a transparent electrode layer.

While in the above-mentioned preparation examples, the CO₂ glow discharge treatment was conducted in an atmosphere containing CO₂ alone, a mixed gas of CO₂ and an inert gas, such as argon, nitrogen or helium, is effective as well. Further, a glow discharge driven by a direct current may be also applied.

Thus, according to the first embodiment of the present invention in which a transparent electrode layer comprising SnO₂ or ZnO is subjected to a CO₂ glow discharge treatment before formation of an a-Si layer, the contact characteristics of the transparent electrode layer to the a-Si layer can be improved while retaining the transmission of SnO₂ or ZnO thereby improving the performance properties of the solar cell.

### EXAMPLE 2

a-Si solar cells according to the second embodiment of the present invention were prepared as follows.

p-Type a-SiC was deposited on a transparent electrode formed on a glass substrate ("7059" produced by Corning Glass Works) by plasma CVD to a thickness of about 3000 to 4000 Å using silane (SiH₄), methane (CH₄), diborane (B₂H₆) and TMB (B(CH₃)₃) as reactive gases. The plasma CVD conditions adopted in Example 2 are shown below.

### Conditions of Plasma CVD:

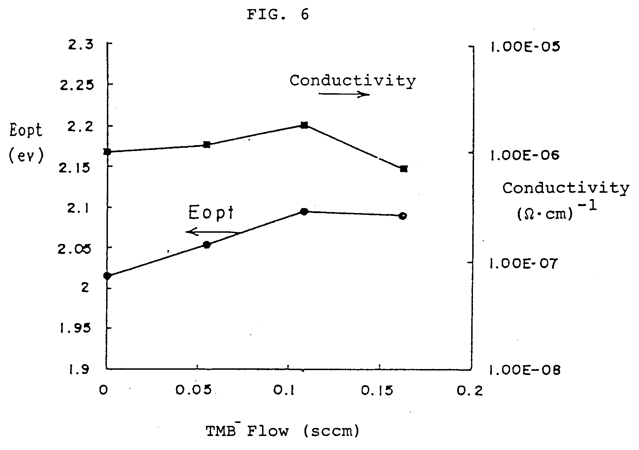

Substrate temperature: 200°C
Pressure: 0.2 Torr
Powder density: about 25 mW/cm²
SiH₄ flow rate: 24 sccm
CH₄ flow rate: 36 sccm
B₂H₆ flow rate: 0.027 sccm
TMB flow rate: varied from 0 to 0.162 sccm
The changes of conductivity and Eₒₚₜ of the resulting solar cells with a TMB flow rate are shown in Fig. 6. The results in Fig. 6 indicate that broadening of Eₒₚₜ can be achieved without being accompanied by a reduction in conductivity by incorporating a proper amount of TMB into a reactive gas mixture of SiH₄, CH₄, and B₂H₆ for formation of p-type a-SiC. That is, Eₒₚₜ, which is about 2.01 eV with no addition of TMB, tends to increase with an increase in TMB flow rate. It reaches about 2.10 eV when the TMB flow rate is raised to about 0.12 sccm, showing an increase of about 0.1 eV over the initial value while retaining the conductivity. As the TMB flow rate is further increased, the conductivity is reduced without bringing no improvement of Eₒₚₜ. This means that the optimum TMB flow rate in terms of a TMB/SiH₄ flow rate ratio is in the vicinity of 0.45%.

There was thus obtained p-type a-SiC having an Eₒₚₜ of 2.1 eV and a conductivity of about 1.0 x 10⁻⁶ (Ω·cm)⁻¹.

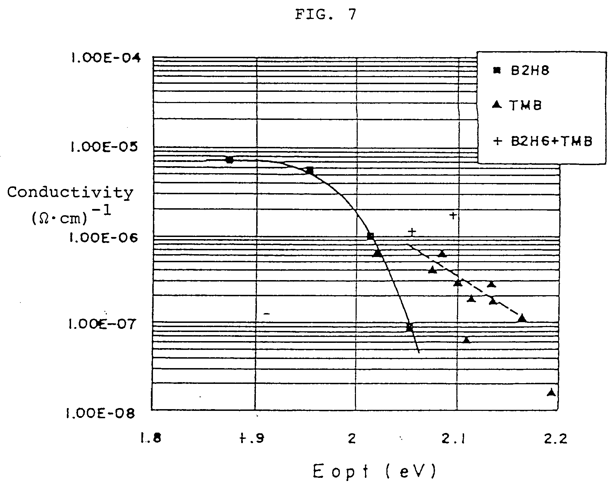

In Fig. 7 is shown the relationship between Eₒₚₜ and conductivity of the samples according to the present invention in comparison with that of a conventional p-type a-SiC layer.

As demonstrated above, the second embodiment of the present invention makes it possible to broaden an Eₒₚₜ by about 0.1 eV without reducing conductivity.

### EXAMPLE 3

a-Si solar cells according to the third embodiment of the present invention were prepared as follows.

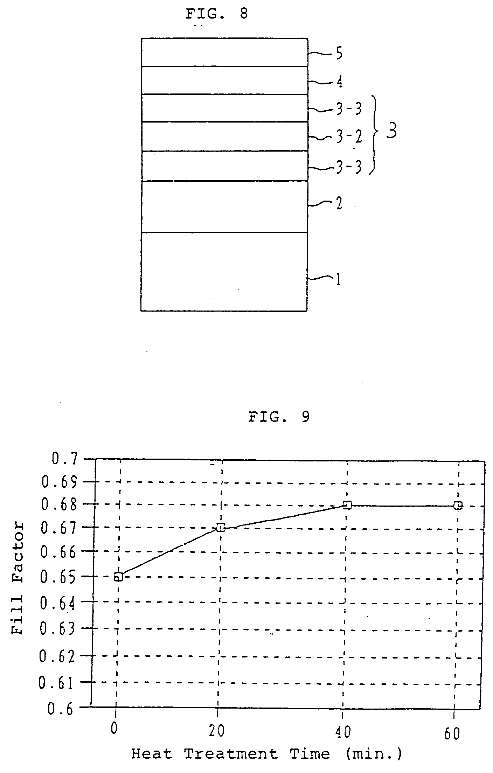

According to the layer structure shown in Fig. 8, SnO₂ was deposited on glass substrate 1 by thermal CVD to a thickness of about 0.45 µm to form transparent electrode layer 2. a-Si layer 3 having a p-i-n junction was then formed on transparent electrode layer 2 by plasma CVD to a thickness of about 0.4 µm. ZnO was deposited on a-Si layer 3 by sputtering using a target material containing about 2% aluminum to a thickness of about 0.1 µm to form first back electrode 4. Silver was then deposited thereon by vacuum evaporation to a thickness of about 0.7 µm to form second back electrode 5.

In the resulting a-Si solar cell, the ohmic junction between the n-type layer 3-3 and first back electrode 4 underwent an increase in shunt resistance or reductions in contact characteristics due to the high resistivity of the ZnO layer. In order to overcome this disadvantage, the solar cell, after formation of back electrodes 4 and 5, was subjected to a heat treatment at a temperature of about 150°C which is approximate to the depositing temperature of an a-Si layer.

Fig. 9 shows the change of fill factor by the heat treatment at about 150°C for a varied treating time. It is apparent from Fig. 9 that the fill factor of the a-Si solar cell can be increased sufficiently by continuing the heat treatment for about 60 minutes.

Various performance characteristics of the thus treated a-Si solar cell and the untreated solar cell with incident light of 100 mW/cm² are shown in Table 2 below.

**TABLE 2**

| Solar Cell | Efficiency (%) | Open Circuit Voltage (V) | Short-Circuited Current (mA/cm²) | Fill Factor |
|---|---|---|---|---|
| Conventional | 10.3 | 0.89 | 17.98 | 0.65 |
| Invention | 10.9 | 0.89 | 17.90 | 0.68 |

It is seen that the conversion efficiency of the solar cell according to the present invention was as high as 10.9%.

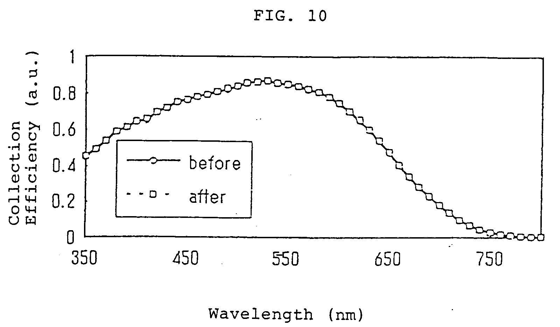

In order to find out the cause of the improvement in fill factor by the heat treatment, the collection efficiency of the a-Si solar cell was determined before and after the heat treatment. The results obtained are shown in Fig. 10. The date obtained before and after the heat treatment substantially agreed with each other. Fig. 10 shows no change in collection efficiency in the longer wavelength region exceeding 650 nm irrespective of the heat treatment. This suggests that the improvement in fill factor by the heat treatment is attributed to a reduction in shunt resistance but not to a reduction in contact resistance between the n-type layer and ZnO. In other words, the heat treatment helps aluminum be sufficiently diffused in the ZnO layer, which leads to a reduction in resistance of the ZnO layer, and as a result the shunt resistance by ZnO can be reduced thereby to improve the fill factor.

As demonstrated above, the third embodiment of the present invention comprising subjecting an n-type a-Si layer with a first back electrode formed by sputtering to a heat treatment makes it possible to provide an a-Si solar cell with improved conversion efficiency due to an improved fill factor.

### EXAMPLE 4

An a-Si solar cell was prepared by combining the first, second and third embodiments of the present invention.

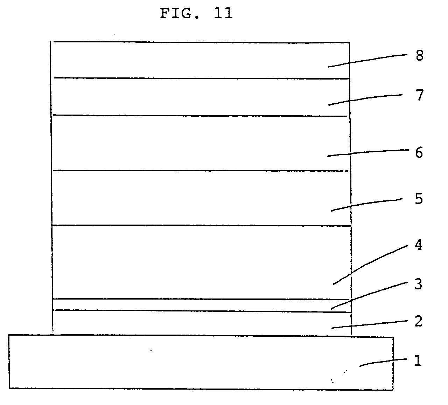

According to the layer structure shown in Fig. 11, SnO₂ was deposited on glass substrate 1 by thermal CVD to a thickness of 4500 Å to form transparent electrode layer 2. Very thin a-SiO layer 3 was then formed on transparent electrode layer 2 by CO₂ glow discharge under the following conditions.
Substrate temperature: 200°C
Pressure: 0.5 Torr
Powder density: 30 mW/cm²
CO₂ flow rate: 30 sccm
Subsequently, p-type a-SiC layer 4 was formed thereon by using a reactive gas mixture of silane, methane, diborane, and TMB under the following conditions.
Substrate temperature: 200°C
Pressure: 0.2 Torr
Powder Density: 30 mW/cm²
SiH₄ flow rate: 24 sccm
CH₄ flow rate: 36 sccm
B₂H₆ flow rate: 9 sccm
TMB flow rate: 0.108 sccm
i-Type layer 5 was formed on p-type layer 4 by using a reactive gas mixture of SiH₄ (40 sccm) and CH₄ (80 sccm) at a power density of 30 mW/cm², and n-type layer 6 was formed thereon by using a reactive gas mixture of argon (60 sccm), SiH₄ (4 sccm), phosphorus hydride (PH₃) (1 sccm), and H₂ (240 sccm) at a powder density of 200 mW/cm².

On n-type layer 6 was deposited ZnO by sputtering to a thickness of about 0.1 µm to form first back electrode 7. Finally, silver was deposited thereon by vacuum evaporation to a thickness of about 0.7 µm to form second back electrode 8.

The resulting solar cell was heat-treated at 150°C to complete an a-Si solar cell.

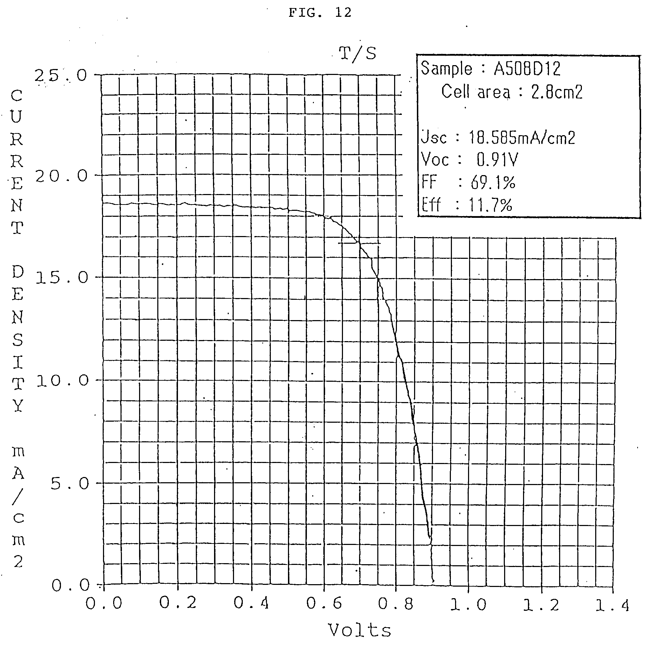

Fig. 12 shows a graph of current vs. voltage of the resulting a-Si solar cell.

While the invention has been described in detail and with reference to specific examples thereof, it will be apparent to one skilled in the art that various changes and modifications can be made therein without departing from the spirit and scope thereof.

## Claims

1. A process for producing an amorphous silicon solar cell comprising an insulating transparent substrate with a transparent electrode layer having formed thereon an amorphous silicon layer having a p-i-n junction and a back electrode layer in this order, which comprises forming an amorphous silicon oxide layer between said transparent electrode layer and a p-type layer by glow discharge in an atmosphere containing carbon dioxide.

2. A process as claimed in Claim 1, wherein said atmosphere for glow discharge is a mixture of carbon dioxide and an inert gas.

3. A process for producing an amorphous silicon solar cell comprising an insulating transparent substrate with a transparent electrode layer having formed thereon an amorphous silicon layer having a p-i-n junction and a back electrode layer in this order, which comprises forming a p-type amorphous silicon carbide layer using a reactive gas mixture comprising silane, methane, and diborane having incorporated therein a proper amount of trimethylboron.

4. A process as claimed in Claim 3, wherein a trimethylboron/silane flow ratio is from 0.3 to 0.6%.

5. A process as claimed in Claim 3, wherein a trimethylboron/silane flow ratio is about 0.45%.

6. A process for producing an amorphous silicon solar cell having a p-i-n junction in which the process including a step in which a first back electrode is formed on said n-type layer by sputtering while doping a metal into a target material, a step of forming a second back electrode on said first back electrode, and a step of conducting a heat treatment after the formation of the second back electrode.

7. A process as claimed in Claim 6, wherein said first back electrode is formed by using zinc oxide doped with aluminum.

8. A process as claimed in Claim 6, wherein said heat treatment is at about 150°C.

9. A process for producing an amorphous silicon solar cell comprising an insulating transparent substrate with a transparent electrode layer having formed thereon an amorphous silicon layer having a p-i-n junction and a back electrode layer in this order, which comprises forming an amorphous silicon oxide layer on said transparent electrode layer by glow discharge in an atmosphere containing carbon dioxide, forming a p-type amorphous silicon carbide layer on said amorphous silicon oxide layer using a reactive gas mixture comprising silane, methane, and diborane having incorporated therein a proper amount of trimethylboron, and after forming an n-type layer, forming a first back electrode on said n-type layer by sputtering while doping a metal into a target material, forming a second back electrode on said first back electrode, and then conducting a heat treatment.

10. A process as claimed in Claim 9, wherein said atmosphere for glow discharge is a mixture of carbon dioxide and an inert gas.

11. A process as claimed in Claim 9, wherein said first back electrode is formed by using zinc oxide doped with aluminum.
